Europäisches Patentamt

European Patent Office

Office européen des brevets

(19)

(11) Numéro de publication : **0 664 590 A1**

(12) ## DEMANDE DE BREVET EUROPEEN

(21) Numéro de dépôt : **95400107.9**

(22) Date de dépôt : **19.01.95**

(51) Int. Cl.[6] : **H01S 3/101,** H01S 3/113

(30) Priorité : **21.01.94 FR 9400645**

(43) Date de publication de la demande :
**26.07.95 Bulletin 95/30**

(84) Etats contractants désignés :
**DE GB IT**

(71) Demandeur : **COMMISSARIAT A L'ENERGIE ATOMIQUE**
**31/33, rue de la Fédération**
**F-75015 Paris Cédex 15 (FR)**

(72) Inventeur : **Valette, Serge**
**41, rue des Eaux Claires**
**F-38100 Grenoble (FR)**

(74) Mandataire : **Dubois-Chabert, Guy**
**c/o BREVATOME**
**25, rue de Ponthieu**
**F-75008 Paris (FR)**

(54) **Laser à direction de faisceau contrôlable.**

(57)    Ce laser comportant une cavité résonante ayant un milieu amplificateur solide (1, 7, 8), un miroir d'entrée (2, 9, 10), un miroir de sortie (3, 11, 12, 21), des moyens optiques (5, 13, 16) pour émettre au moins un faisceau de pompage du milieu amplificateur, se caractérise en ce qu'il comporte des moyens pour faire varier la direction du faisceau de pompage dans le milieu amplificateur, et en ce que la cavité a une géométrie permettant de générer un faisceau laser, quelle que soit la direction du faisceau de pompage.

FIG. 1

EP 0 664 590 A1

## Domaine technique

La présente invention a pour objet un laser à direction de faisceau contrôlable.

Elle trouve une application en optique, en physique, en télécommunications optiques, en détection optique (LIDAR), en usinage de matériaux, etc...

## Etat de la technique

Bien que l'invention ne se limite pas aux microlasers, c'est dans ce contexte particulier que l'invention va être décrite, car c'est là qu'elle trouve une application privilégiée.

Les microlasers ou lasers "puce" (ou "microchip lasers" en terminologie anglo-saxonne) constituent une nouvelle famille de lasers présentant de nombreux avantages. Un microlaser est constitué d'un milieu amplificateur en général de faible longueur (allant typiquement de 100 μm à quelques millimètres) encadré par deux miroirs. Ce milieu est pompé optiquement par un faisceau issu généralement d'une diode laser. La puissance de cette diode va généralement d'une centaine à quelques milliers de milliwatts.

Le rendement des microlasers est de l'ordre de 20 à 30%, de sorte qu'ils émettent des puissances de l'ordre de plusieurs dizaines de milliwatts en continu, voire de plusieurs centaines de milliwatts.

Par rapport aux diodes lasers individuelles, ils présentent des avantages importants.

Ainsi, ce sont d'excellents convertisseurs de cohérence, à la fois spatiale et temporelle.

D'autre part, du fait de la mise en jeu de niveaux énergétiques bien définis pour l'émission laser et non des bandes d'émission comme dans les diodes lasers semi-conductrices, les caractéristiques de l'émission d'un laser solide sont moins dépendantes de l'environnement, et en particulier de la température, que celle de l'émission d'une diode laser.

L'un des intérêt de ce type de laser est leur mode de fabrication collective. Il suffit en effet de revêtir une plaquette de matériau amplificateur de couches réfléchissantes appropriées et de découper des microlasers dans l'ensemble. Comme on peut partir d'une plaquette de plusieurs centimètres de diamètre et qu'un seul millimètre carré de section suffit à réaliser un microlaser, il est possible de réaliser, en un seul cycle d'opérations techniques, plusieurs dizaines ou centaines de microlasers.

Le coût de ces composants tombe ainsi à une valeur très basse.

Les lasers fonctionnant avec un faisceau de pompage continu émettent un faisceau de lumière continu. Cependant, l'un des avantages des lasers solides pompés par des diodes lasers est qu'ils utilisent des matériaux amplificateurs dont la durée de vie radiative est relativement longue (de 100 μs à 10 ms) comparativement aux durées de vie impliquées dans les diodes lasers, (qui sont de l'ordre de la nanoseconde). Il est donc possible de réaliser des lasers déclenchés capables d'émettre des impulsions lumineuses très brèves (d'une fraction de nanosecondes à quelques dizaines de nanosecondes) en stockant l'énergie produite par le pompage optique pendant une durée de l'ordre de la durée de vie radiative du matériau et en restituant toute cette énergie durant un temps très court.

On ne peut obtenir ce type d'impulsions brèves et intenses avec une diode laser seule, compte tenu des durées de vie radiatives très faibles observées dans les semi-conducteurs (quelques nanosecondes). Ces très faibles durées de vie limitent la durée de stockage possible et font ainsi perdre tout intérêt à ces solutions.

Pour toute ces raisons, les microlasers apparaissent de plus en plus comme des sources de lumière complémentaires des diodes lasers, et tout aussi indispensables.

Parmi les applications visées, la réalisation de microlidars pour la détection d'obstacle semble devoir prendre une importance particulière.

Les principes mis en jeu peuvent être multiples mais reposent toujours sur la mesure du temps mis par un faisceau laser pour parcourir la distance d'un aller-retour entre le point d'émission, l'obstacle qui renvoie (en général par diffusion) une partie du faisceau de lumière vers le détecteur, et ce dernier. Pour cela, on peut utiliser des mesures de phase associées à des rampes de fréquence (détection hétérodyne) ou des mesures de temps de vol d'une impulsion laser très courte. Dans le premier cas, le laser utilisé émet en continu, dans le deuxième cas en impulsions.

Il existe bien sûr de nombreuses variantes à ces deux modes de fonctionnement bien connus.

Pour les applications dans le domaine de l'automobile, par exemple, cette détection d'obstacle doit, si possible, se faire non pas dans une seule direction mais dans plusieurs directions à la fois afin d'obtenir une véritable "image" des obstacles situés au devant du véhicule.

Ceci nécessite l'emploi d'un réseau de microlidars, ce qui exige un montage complexe avec des moyens mécaniques, susceptibles de subir des déformations du fait des accélérations ou des mouvements importants que peut effectuer un véhicule automobile à bord duquel est embarqué ce type de système.

On a donc besoin d'un système plus simple évitant le plus possible la présence de parties mécaniques.

Par ailleurs, on a également besoin d'un système incorporant des moyens de déclenchement se présentant sous une forme simple, permettant de garder la structure compacte du microlaser, évitant au mieux l'introduction de colle optique, la nécessité de réglages optiques en cours d'utilisation et la solution de type codopage qui ne permet pas de régler indépendamment les propriétés du matériau laser et d'un absorbant saturable.

A notre connaissance, ce type de système n'a jamais été proposé, ni dans le cadre plus général des lasers, ni dans celui plus particulier des microlasers.

## Exposé de l'invention et brève description des figures

La présente invention a justement pour objet de répondre à ce besoin.

Plus précisément, elle a pour objet un microlaser comportant une cavité résonante ayant un milieu amplificateur solide, un miroir d'entrée, un miroir de sortie, des moyens optiques pour émettre au moins un faisceau de pompage du milieu amplificateur, caractérisé en ce qu'il comporte une couche mince d'absorbant saturable déposée dans la cavité, des moyens pour faire varier la direction du faisceau de pompage dans le milieu amplificateur et en ce que la cavité a une géométrie permettant de générer un faisceau laser, quelle que soit la direction du faisceau de pompage.

Les moyens de pompage peuvent être constitués d'une matrice de sources de lumière commandables individuellement ou en groupe. Ils peuvent aussi être constitués d'au moins une source de lumière, et de moyens pour déplacer cette source dans l'espace.

Selon un mode de réalisation de l'invention, au moins le miroir d'entrée est un miroir sphérique, et les moyens pour faire varier la direction du faisceau de pompage comportant une lentille de focalisation, située sur le trajet du faisceau de pompage, de telle façon que le foyer image de cette lentille soit approximativement confondu avec le centre de courbure du miroir sphérique.

Plus précisément, le deuxième miroir est sphérique, les centres de courbure des deux miroirs étant approximativement confondus.

Selon une variante de ce premier mode préféré de réalisation de l'invention, le miroir de sortie est plan, ou légèrement concave ou légèrement convexe

Les moyens de pompage peuvent aussi être constitués d'une barrette de sources de lumière commandable individuellement ou en groupe.

Selon un deuxième mode de réalisation de l'invention, le miroir d'entrée est un miroir cylindrique et les moyens pour faire varier la direction du faisceau de pompage comportent une lentille de focalisation cylindrique, située sur le trajet du faisceau de pompage de telle façon que les deux axes de symétrie cylindrique, respectivement du miroir d'entrée et de la lentille, soient disposés selon une même direction et que, dans tout plan perpendiculaire à cette direction, le point focal image de la lentille soit approximativement confondu avec le centre de courbure du miroir dans ce même plan.

Plus précisément, le miroir de sortie est également à symétrie cylindrique.

Selon une variante de ce deuxième mode de réalisation de l'invention, le miroir de sortie est plan ou légèrement concave ou légèrement convexe, la concavité ou la convexité étant alors à symétrie cylindrique avec un axe parallèle à l'axe de symétrie cylindrique du miroir d'entrée

De toute façon, les caractéristiques et avantages de l'invention apparaîtront mieux à la lumière de la description qui va suivre. Cette description porte sur les exemples de réalisations, donnés à titre explicatif et non limitatif. Elle se réfère par ailleurs à des dessins annexés sur lesquels :
- la figure 1 représente en perspective un premier mode préféré de réalisation de l'invention,
- la figure 2 représente, en coupe, un premier mode préféré de réalisation de l'invention,
- la figure 3 représente, en coupe, une variante du premier mode préféré de réalisation de l'invention,
- la figure 4 représente un second mode préféré de réalisation de l'invention,
- la figure 5 représente une variante du second mode préféré de réalisation de l'invention.
- les figures 6a à 6d représentent différentes étapes d'un procédé de réalisation de miroirs sphériques pour un microlaser selon l'invention,
- la figure 7 représente le milieu actif d'un microlaser avec une cellule de déclenchement acousto-optique,
- la figure 8 représente une première étape de réalisation d'une plaquette acousto-optique,
- les figures 9a à 9d représentent des exemples de profils obliques pouvant être obtenus par gravure anisotrope sur plaquette d'orientation de surface (100), pour la réalisation d'une plaquette acousto-optique.
- la figure 10 représente une réalisation de l'invention avec cavité de type concentrique et avec une cellule de déclenchement électro-optique ou acousto-optique,
- la figure 11 représente une autre réalisation de l'invention avec cavité de type concentrique et avec une cellule de déclenchement électro-optique ou acousto-optique,
- la figure 12 représente un exemple d'intégration d'un microlaser selon l'invention.

## Exposé détaillé de modes de réalisation

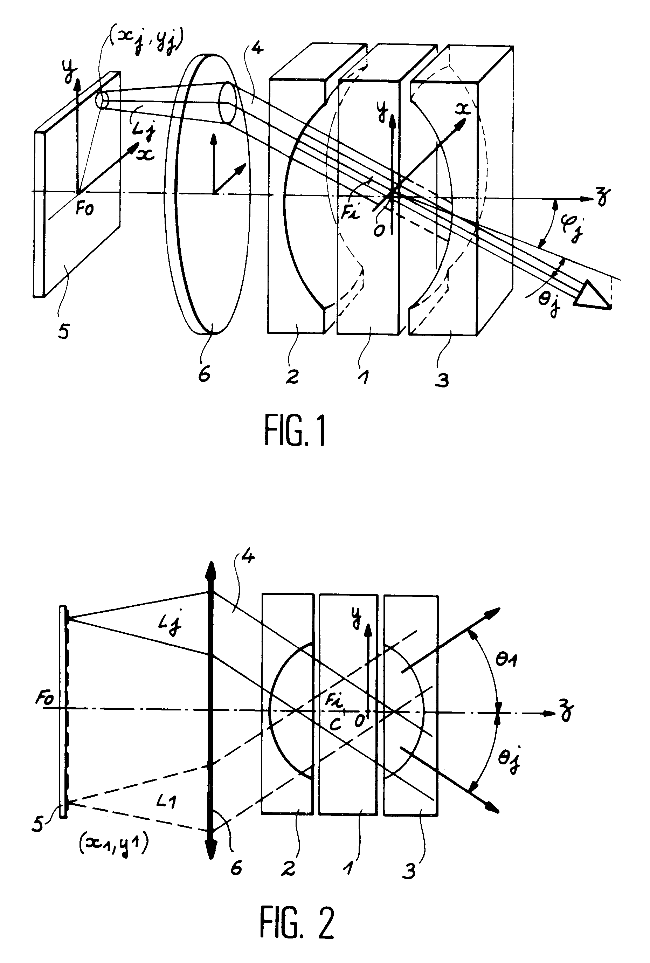

Un premier mode préféré de réalisation de l'invention est représenté, en perspective sur la figure 1, et en coupe sur la figure 2 où la référence 1 désigne un milieu amplificateur laser, par exemple un solide.

De façon classique, le matériau constitutif du milieu amplificateur 1 sera dopé au néodyme (Nd) pour une émission laser autour de 1,06 μm. Ce matériau pourra être choisi, par exemple, parmi l'un des matériaux suivants : YAG ($Y_3Al_5O_{12}$), LMA ($LaMgAl_{11}O_{19}$), $YVO_4$, YSO ($Y_2SiO_5$), YLF ($YLiF_4$) ou $GdVO_4$, etc.

Pour des émissions à d'autres longueurs d'ondes on choisira des matériaux et des dopants différents. En général, les ions actifs sont choisis parmi :

- Nd pour une émission autour de 1,06 μm,
- Er ou un codopage erbium-ytterbium Er+Yb pour une émission autour de 1,5 μm,
- Tm ou Ho ou un codopage de thulium et d'holmium (Tm-Ho) pour une émission autour de 2 μm.

Un autre paramètre décisif est l'épaisseur $e$ du milieu actif. Il conditionne les caractéristiques du microlaser puisque l'absorption du faisceau pompe sera d'autant plus forte que l'épaisseur $e$ sera grande et puisqu'il conditionne la répartition spectrale des modes de la cavité. En pratique, l'épaisseur $e$ variera entre 100 μm et 15 mm.

La fabrication du milieu amplificateur laser, dans le cas des microlasers comportera trois étapes :

- choix du matériau de base constitutif du cristal et choix de l'ion actif,
- conditionnement du cristal laser choisi : on le découpe en lames d'épaisseur comprise entre 0,1 et 15 mm,
- rodage et polissage des lames, afin d'une part, d'enlever la couche d'écrouissage superficielle due à la découpe, et d'autre part, de ramener l'épaisseur des lames à une épaisseur légèrement supérieure à la spécification du microlaser.

Les lames rodées et rapprochées de l'épaisseur finale sont polies sur les deux faces avec une qualité optique.

La découpe, le rodage et le polissage sont faits avec des procédés connus, en utilisant des machines connues de l'homme du métier.

Le procédé décrit est un procédé qui permet la fabrication en grande série, donc à bas coût de production.

Sur les figures 1 et 2, le milieu amplificateur est encadré par deux miroirs 2 et 3, le miroir 2 étant un miroir d'entrée pour un faisceau 4 de pompage du milieu amplificateur 1.

Selon ce premier mode préféré de réalisation, la cavité possède une symétrie de révolution par rapport à un axe z. Si on choisit un point O origine de façon arbitraire sur l'axe z, et un système d'axes Oxyz orthonormé, l'inclinaison du faisceau 4 dans le milieu amplificateur est définie par rapport au système d'axes Oxyz par deux angles $\varphi_j$ et $\theta_j$ (voir figures 1 et 2) : $\theta_j$ correspond à l'angle entre l'axe de propagation du faisceau de pompage et le plan xOz et $\varphi_j$ correspond à l'angle entre la projection de cet axe de propagation dans le plan xOz et l'axe z.

La référence 5 désigne une matrice de sources de lumière adressables, individuellement ou en groupe, de façon séquentielle. On peut choisir ces sources parmi les sources de pompage optique usuelles des milieux lasers ou microlasers, par exemple diodes lasers classiques, diodes électroluminescentes (pour des microlasers pouvant fonctionner à très faibles seuils), ou microlasers semi-conducteurs à cavité verticale (VCSEL).

Si on utilise des diodes lasers classiques, il existe déjà dans le commerce des matrices de ce type de diode, communément appelées "stack". Néanmoins, ce type de matrice nécessite une adaptation car elles sont toujours vendues dans une version où toutes les diodes de la matrice sont déclenchées simultanément.

La matrice 5 de sources de lumière sera de préférence située au foyer objet $F_o$ d'une lentille de focalisation 6, dont le foyer image $F_i$ est situé soit au sein du milieu amplificateur 1, soit éventuellement à l'intérieur de moyens de déclenchement de la cavité, lorsque de tels moyens sont incorporés au sein du milieu amplificateur, ainsi qu'il est expliqué plus loin.

D'autre part, selon ce premier mode préféré de réalisation de l'invention, on peut choisir pour cavité une cavité formée par deux miroirs sphériques, dont les centres de courbure sont confondus ou approximativement confondus avec le foyer image $F_i$, mais dont les rayons de courbure ne sont pas nécessairement égaux.

Ainsi, la sélection ou l'adressage d'une source, repérée par ses coordonnées $(x_j, y_j)$ dans un repère $(F_o,x,y)$ de la matrice 5 permet d'obtenir un faisceau $L_j$, qui est dévié par la lentille 6 en direction du milieu amplificateur et qui passe par le point focal $F_i$. Si, en outre, $F_i$ est confondu avec le centre de courbure commun de chaque miroir, le faisceau va pouvoir effectuer à l'intérieur de la cavité des aller-retour et osciller suivant une direction définie par les angles $\varphi_j$ et $\theta_j$, ce qui engendre un faisceau laser suivant cette même direction, et ceci quels que soient les angles $\varphi_j$ et $\theta_j$.

Les angles $\varphi_j$ et $\theta_j$ dépendent de la position $(x_j,y_j)$ de la source sélectionnée dans le plan de la matrice 5 et de la distance focale f de la lentille 6. Plus précisément, on a :

$$tg\theta_j = \frac{y_j}{f} \text{ et } tg\varphi_j = \frac{x_j}{f}$$

En sélectionnant par exemple un point $(x_1,y_1)$ (voir figure 2), on obtient un faisceau défini par ($\varphi_1$ et $\theta_1$) :

$$tg\theta_1 = \frac{y_1}{f} \text{ et } tg\varphi_1 = \frac{x_1}{f}$$

et une émission laser suivant cette deuxième direction ($\varphi_1$, $\theta_1$).

La dynamique du système est définie par :

$$tg\theta_{jmax} = \frac{y_{jmax}}{f} \text{ et } tg\varphi_{jmax} = \frac{x_{jmax}}{f}$$

$y_{jmax}$ et $x_{jmax}$ étant les coordonnées maximums possibles pour une source dans le plan ($F_o$, x, y).

Par exemple, il a été réalisé une matrice constituée d'un ensemble de microlasers à cavité verticale, définissant ainsi des pixels de taille 30 μmx30 μm ; la puissance émise par pixel étant de l'ordre de 10 mW, une zone de 300 μmx300 μm émet une puissance de l'ordre du Watt, ce qui est largement suffisant pour le pompage d'un microlaser. en prenant $x_{jmax}$=1 mm=$y_{jmax}$ et une focale f=4 mm, on a :

$$\theta_{jmax} = 12° \text{ et } \varphi_{jmax} = 12°$$

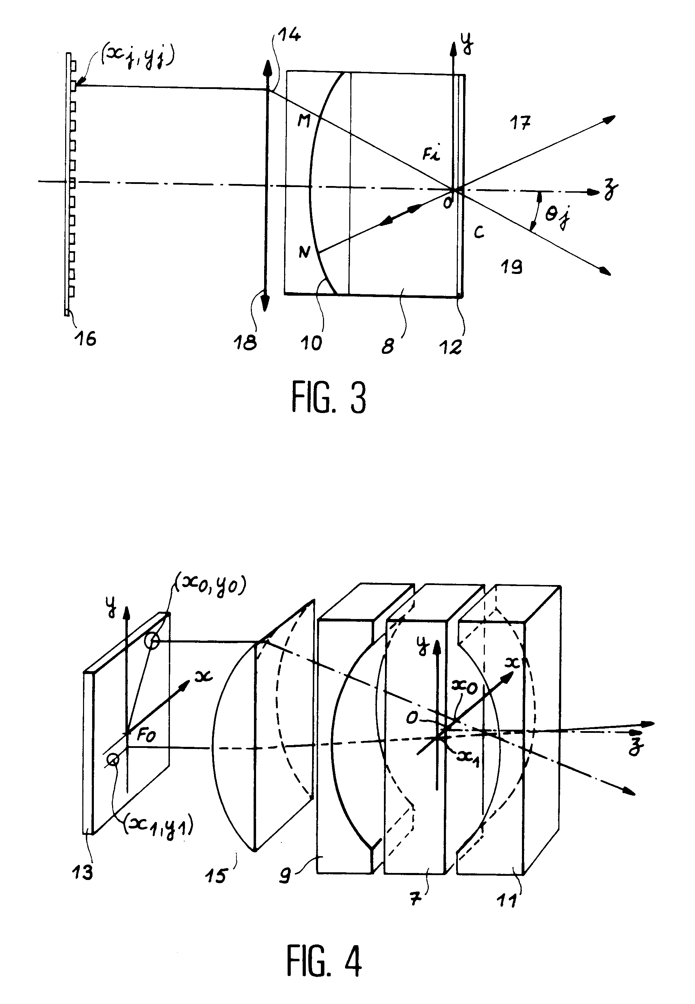

Une variante de ce premier mode préféré de réalisation de l'invention est illustrée sur la figure 3. La référence 8 y désigne le milieu amplificateur, les références 10 et 12 les miroirs d'entrée et de sortie du faisceau de pompage 14, la référence 16 une matrice de sources de lumière (là encore diodes laser classiques, diodes électroluminescentes ou microlaser semi-conducteur à cavité verticale) et la référence 18 une lentille convergente. La cavité est encore à symétrie de révolution autour d'un axe Oz. Elle est constituée d'un miroir courbe, par exemple sphérique, à l'entrée et d'un miroir plan, ou légèrement concave, ou légèrement convexe à la sortie. Le centre de courbure C du miroir d'entrée se trouve au niveau du plan tangent au miroir de sortie qui est perpendiculaire à Oz, le foyer image $F_i$ de la lentille 18 étant confondu ou approximativement confondu avec C, comme dans le cas précédent.

Dans cette variante, le faisceau de pompage traverse le miroir 10 en un point M, pénètre au sein du milieu actif laser 8 et se propage en direction du point $F_i$ où il est réfléchi vers le miroir sphérique, mais en direction d'un point N, symétrique du point M par rapport à l'axe Oz de révolution. A ce point, le rayon est réfléchi vers $F_i$ puis vers le point M et ainsi de suite. On obtient donc, là encore, une oscillation intracavité quels que soient les angles $\varphi_j$ et $\theta_j$. Mais le résultat final est en général l'émission de deux- faisceaux laser 17 et 19, symétriques par rapport à l'axe Oz.

Là encore, l'inclinaison ($\theta_j$,$\varphi_j$) des deux faisceaux dans un repère (Oxyz) (où Ox est perpendiculaire au plan de la figure 3) dépendra du point source choisi dans la matrice 16 et des caractéristiques géométriques et optiques des composants.

Dans l'application à la détection d'obstacle, on peut obtenir, avec cette variante, des informations en provenance de deux directions différentes, symétriques par rapport à l'axe optique du système.

Dans les deux cas décrits ci-dessus, l'adressage des différentes sources dans la matrice (5, 16) sera réalisé par des moyens électroniques classiques connus de l'homme du métier. Cet adressage peut être piloté par exemple par un microprocesseur.

On obtient ainsi un faisceau laser pouvant être orienté, par exemple à l'intérieur d'un cône ellipsoïdal dont l'ouverture sera définie par la taille de la matrice et par les caractéristiques des éléments optiques (distance focale, notamment).

On pourra remplacer la matrice (5, 16) par une seule source de lumière déplacée par un système de commande électromécanique, par exemple un bras actionné par exemple par un moteur électrique lui-même piloté par un microprocesseur.

Selon un deuxième mode de réalisation préféré de l'invention, il est possible de réaliser un système dans lequel chaque miroir présente une courbure finie dans le plan yOz, mais pas de courbure dans le plan xOz. L'ensemble ne possède alors plus de symétrie de révolution autour de Oz, mais une symétrie plane, par rapport au plan xOz (le point 0 est alors choisi arbitrairement dans le plan de symétrie). C'est le cas pour des miroirs de type cylindrique, notamment à section droite circulaire ou en arc de cercle, la lentille de focalisation étant alors également de type cylindrique, notamment à section droite circulaire ou en arc de cercle. Il faut alors que, dans chaque plan parallèle à yOz, le point focal $F_i$ et le centre de courbure de chaque miroir soient confondus ou approximativement confondus. Ce qui revient à dire que les trois axes de symétrie cylindrique sont parallèles entre eux et situés dans le plan xOz Mais les courbures des deux miroirs peuvent être différentes l'une de l'autre.

Ce deuxième mode de réalisation préféré est illustré en perspective sur la figure 4, où la référence 7 désigne le milieu actif solide du laser, les références 9 et 11 les miroirs, par exemple cylindriques à section droite circulaire ou en arc de cercle, d'entrée et de sortie, la référence 13 une matrice de sources de lumière et la référence 15 une lentille convergente, par exemple cylindrique à section droite circulaire ou en arc de cercle. Le résultat obtenu est un faisceau laser à angle $\theta_j$ orientable dans un plan vertical et à abscisse $x_j$ variable. Le faisceau de pompage et le faisceau laser résultants, pour un élément sélectionné de la matrice 13, sont tous contenus dans un plan vertical (plan parallèle à yOz). Si on adresse simultanément deux éléments ($x_j$,$y_j$) et ($x_j$, $y'_j$) de la matrice, ces deux éléments ayant la même abscisse $x_j$ dans le plan de la matrice 13, l'ensemble des faisceaux définira encore un seul plan vertical, parallèle à yOz et l'inclinaison de chaque faisceau laser sera respectivement $\theta_j$ et $\theta_{j'}$ avec $tg\theta_j = \frac{y_j}{f}$ et $tg\theta_{j'} = \frac{y_{j'}}{f}$. Si on adresse deux éléments d'abscisses $x_o$ et $x_1$ différentes, on obtient deux ensembles faisceau de pompage-faisceau laser définissant deux plans verticaux parallèles décalés de la différence $|x_o-x_1|$, comme illustré sur la figure 4.

On peut également, selon une variante non représentée, remplacer la matrice de diodes par une barrette de sources de lumière disposée selon un axe parallèle à $F_o y$ (voir figure 4), commandables individuellement ou en groupe. On obtient alors un faisceau laser contenu dans un plan parallèle à yOz, et dont seule l'orientation $\theta_j$ est variable.

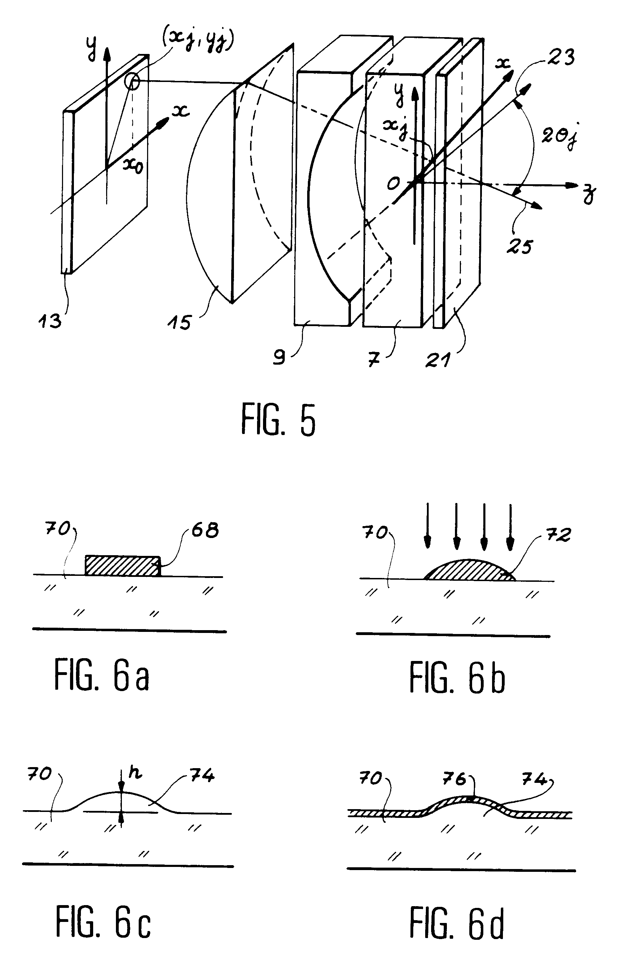

Selon une variante de ce second mode de réalisation, illustré sur la figure 5, la cavité est encore à symétrie plane (le plan de symétrie étant confondu avec xOz), le miroir 9 présentant une courbure finie dans le plan yOz, mais pas de courbure dans le plan xOz. Le miroir d'entrée 9 est par exemple de type cylindrique, ainsi que la lentille de focalisation 15, l'axe de chaque cylindre étant parallèle à l'axe Ox (voir figure 5).

Le miroir de sortie 21 est plan ou éventuellement légèrement convexe ou concave. Mais, dans ce cas, il n'y a concavité ou convexité que dans le plan yOz et dans tout plan vertical qui lui est parallèle, de façon à respecter la symétrie plane par rapport au plan xOz. Ainsi, le miroir 21 est un miroir d'axe parallèle aux précédents et situé dans le plan xOz.

Si dans tout plan parallèle à yOz, le centre de courbure C du miroir d'entrée et le foyer image Fi de la lentille 15 sont confondus ou approximativement confondus et se trouvent au niveau du plan tangent au miroir de sortie, on obtient, pour chaque élément $y_j$ adressé dans la matrice 13, deux faisceaux lasers 23 et 25 symétriques par rapport au plan xOz, contenus dans le plan d'équation $x=x_j$ dans le repère (Oxyz), l'angle $2\theta_j$ (figure 5) étant variable ainsi que l'abscisse $x_j$ sur l'axe Ox.

Là aussi, on peut remplacer la matrice par une barrette de sources de lumière disposée parallèlement à $F_o y$ et ayant l'abscisse $x_i$, commandables individuellement ou en groupe, et obtenir ainsi, pour chaque élément $(x_i, y_j)$ adressé dans la barrette, deux faisceaux lasers symétriques par rapport au plan xOz, contenus dans le plan d'équation $x=x_i$, l'angle $\theta_j$ étant variable en fonction de l'ordonnée $y_j$ sur l'axe $(F_o y)$.

De même que dans le premier mode de réalisation, il est possible de remplacer la matrice 13 de sources (ou la barrette) par une seule source dont la position dans l'espace est pilotée par des moyens mécaniques et électroniques.

Le procédé de réalisation des miroirs dans le cas des lasers "classiques" (par opposition aux microlasers) peut être un des procédés usuels de réalisation de miroirs, connus de l'homme de l'art.

Pour former les miroirs dans le cas des microlasers, on peut utiliser une technique dite "par fluage". Pour cela, on dispose, ainsi qu'illustré sur la figure 6a, une couche de matériau photosensible déformable, par exemple une résine, gravée sous forme de plots 68 (figure 6a) sur une paroi 70, transparente à la longueur d'onde du laser, par exemple en silice. Ces plots ont une forme quelconque carrée, circulaire ou elliptique. Ces plots sont chauffés et, par fluage, ils prennent la forme lenticulaire 72 illustrée sur la figure 6b et servent de masques.

On effectue ensuite une gravure d'épaisseur h de la paroi 70 (gravure sèche ou humide) à travers les masques 72, ce qui laisse subsister, après élimination des masques, des microlentilles 74 d'épaisseur h (figure 6c). Pour des rayons de courbure de 1 mm à 10 mm et pour des diamètres de lentilles de 100 à 500 $\mu$m, la hauteur h est comprise entre environ 0,1 $\mu$m et 30 $\mu$m.

Ces microlentilles sont revêtues d'une ou plusieurs couches réfléchissantes 76 à la longueur d'onde du faisceau laser (figure 6d), par exemple par dépôt de multicouches diélectriques.

Tel que décrit ci-dessus, ce procédé permet la production de "micromiroirs" sphériques. Il peut s'appliquer aussi à la production de miroirs cylindriques. Mais dans ce cas, il faut veiller à déposer, au départ, le matériau photosensible déformable, non pas sous la forme de plots (comme sur la figure 6a), mais sous la forme de bandes. Et il faut déposer une bande d'une longueur suffisante pour ne pas être gêné par les effets de bords se produisant inévitablement aux extrémités de la bande, lors du fluage, et qui affectent la symétrie cylindrique.

Dans tous les cas, ce procédé "par fluage" permet une production de "micromiroirs" à grande échelle et donc, là encore, à faible coût de production.

Un autre procédé de formation permet d'obtenir des miroirs déposés sur des formes "en creux", comme les miroirs 2 et 3 des figures 1 et 2. Pour cela, on peut, dans un premier temps, réaliser par fluage la forme du miroir "en bosse". Puis, on procède par moulage et par dépôt de couches réfléchissantes sur la forme moulée obtenue. Là encore, le procédé s'étend à une production à grande échelle.

Tous les modes de réalisation et toutes les variantes décrits peuvent fonctionner en régime déclenché, en incorporant à l'intérieur de la cavité un absorbant saturable, ou des moyens électro-optiques ou des moyens acousto-optiques. Tous ces moyens peuvent être utilisés soit avec un laser classique, soit avec un microlaser.

Leur utilisation avec un laser classique est connue. On pourra se reporter, à ce sujet à l'ouvrage de W. Koechner intitulé "Solid-State Laser Engineering" publié par Spinger Verlag, et en particulier le chapitre intitulé "Q-Switches and External Switching Devices", p. 402-448.

Dans le cas des microlasers, il est apparu récemment des microlasers déclenchés, utilisant des moyens électro-optiques. Dans les comptes rendus du Congrès CLEO qui s'est tenu aux Etats-Unis en mai 1992, J.J. ZAYHOWSKI et al. ont décrit un microlaser déclenché (communication CM17 intitulé "Diode-pumped Electro-Optically Q-Switched Microchip Lasers") constitué par un microbarreau de Nd:YAG de 532 $\mu$m de long accolé à un microbarreau de Li-

TaO₃ de 904 μm de long. Des électrodes sont déposées sur les deux faces perpendiculaires à l'axe C du cristal de LiTaO₃, lequel axe C est lui-même perpendiculaire à l'axe général du laser. Des impulsions de 600 V de durée 100 ns sont appliquées aux électrodes et l'on obtient des impulsions lumineuses déclenchées de durée inférieure à 2 ns. Pour réaliser ce type de cellule électrooptique dans le cas d'un microlaser, on se reportera donc à l'article de ZAYHOWSKI et al.

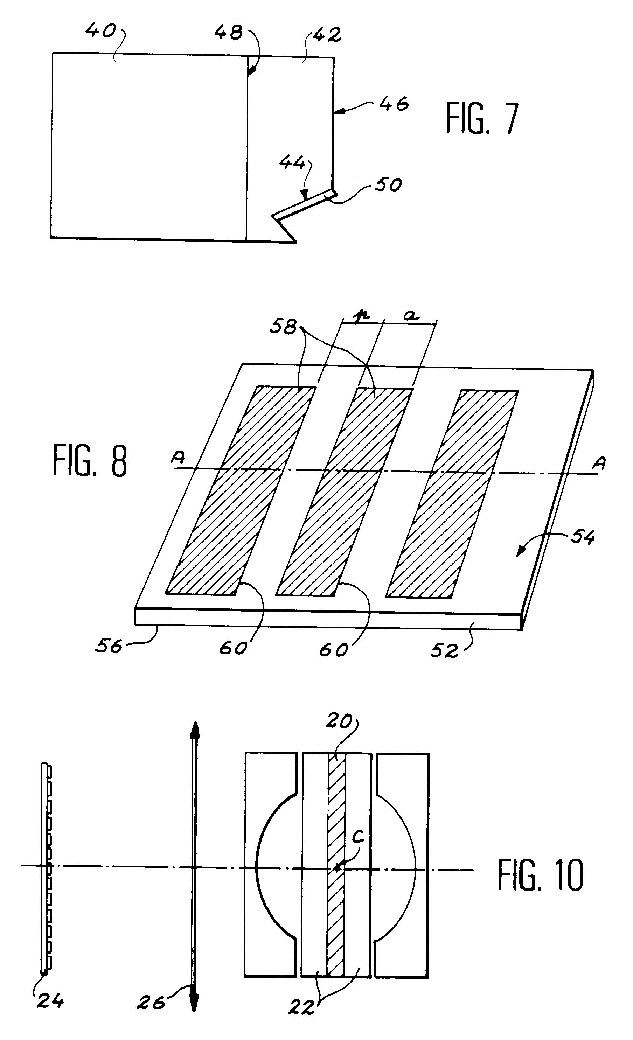

Est également connu un microlaser déclenché par dispositif électroacoustique. Un tel microlaser est décrit dans la demande de brevet FR-93 04375 déposée le 14 AVRIL 1993 ainsi que le procédé de réalisation du dispositif électroacoustique. Une partie de ce microlaser est illustrée sur la figure 7 où est représenté un bloc amplificateur laser 40 assemblé à une microcellule de déclenchement acousto-optique. Cette microcellule comprend un bloc 42, ce bloc ayant une face gravée 44 qui est un plan cristallographique, ainsi qu'une face avant 46 et une face arrière 48 orientées par rapport à ce plan. Enfin, des moyens piézoélectriques 50 pour engendrer une onde acoustique sont déposés sur la face gravée.

Pour ce qui est du matériau constitutif du bloc 42, on le choisira, de préférence, parmi des matériaux qui répondent aux caractéristiques suivantes :

- les matériaux doivent être usinables sur de fortes épaisseurs (plusieurs centaines de microns) avec des méthodes convenables assurant une qualité de surface excellente ; c'est en particulier le cas des techniques d'attaque anisotrope ;

- ces matériaux doivent présenter de faibles pertes acoustiques à haute fréquence (50 dB/(cm.Ghz²) apparaît être une limite supérieure : cela correspond à environ 1 dB de pertes sur 1 mm de propagation à 500 MHz, qui sera l'ordre de grandeur des fréquences acoustiques utilisées) ;

- la transparence doit être convenable pour des longueurs d'onde d'émission des microlasers, idéalement une transparence au-delà de 0,9 à 1 μm en longueur d'onde est recherchée ; cependant, beaucoup d'applications vers 1,5 μm et entre 2 et 3 μm sont actuellement visées.

Les matériaux remplissant ces conditions sont notamment le silicium Si, le germanium Ge, l'arséniure de gallium GaAs, le phosphure d'indium InP et le phosphure de gallium GaP. Ils sont tous disponibles en surface et en qualité convenables et peuvent s'usiner chimiquement avec des solutions d'attaque connues et avec des vitesses d'attaque fortement dépendantes des plans cristallins.

Avantageusement, le procédé de réalisation d'une microcellule de déclenchement acousto-optique 42 exploite les propriétés de la gravure anisotrope, telle que celle obtenue par attaque chimique préférentielle. On sait qu'il s'agit là d'une méthode de gravure reposant sur la différence de vitesse de gravure entre différents plans cristallographiques d'un même matériau pour certains agents d'attaque.

En général, la vitesse d'attaque est très lente suivant l'un des plans cristallins (les plans de type (111) par exemple) et très rapide suivant les autres.

On obtient donc des géométries de gravure particulières qui découlent de cette propriété et dont la forme est imposée par les configurations angulaires des plans d'attaque lente et par l'orientation initiale des cristaux.

On peut appliquer ce procédé au silicium, dont les propriétés à cet égard sont bien connues. Mais des configurations tout à fait similaires peuvent être obtenues avec le germanium ou avec les semiconducteurs composés tels que GaAs ou InP ou autres. Il faut simplement prendre garde, dans ce dernier cas, à la présence de deux types de plans atomiques.

Pour mettre en oeuvre une telle gravure sur de grandes profondeurs, il faut également disposer d'un matériau de masquage suffisamment résistant à l'agent d'attaque.

Plus précisément, pour réaliser une cellule acousto-optique (ou plutôt une pluralité de telles cellules, le procédé permettant en effet une production à grande échelle), on partira, comme illustré sur la figure 8, d'une plaquette 52 en matériau cristallin convenablement choisi (voir les critères ci-dessus) et convenablement orienté, avec une face avant 54 et une face arrière 56. Ce matériau possède des plans cristallographiques. L'un de ces plans coupe la face avant 54 selon une certaine direction. Sur la face avant 54, on dépose alors un masque formé d'une matrice de motifs 58 (bandes rectangulaires de largeur a, séparées d'une distance p), ayant au moins un bord 60 parallèle à la direction selon laquelle le plan cristallographique choisi coupe la face avant 54.

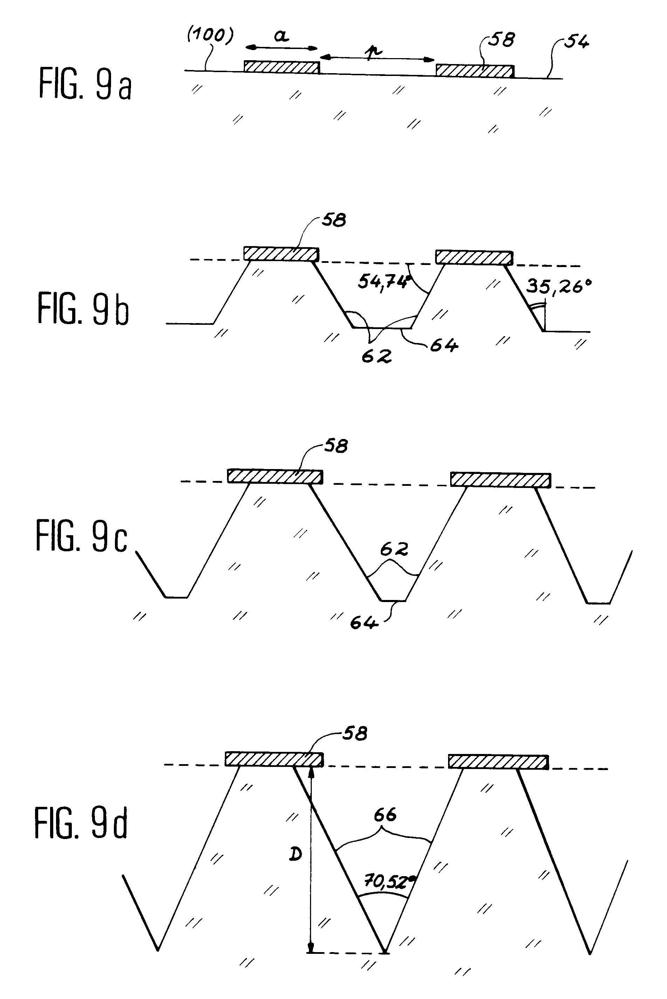

Les figures 9a-d montrent, en coupe, plusieurs étapes dans la gravure de la plaquette 52, dans le cas où cette plaquette est en silicium avec une face avant 54 orientée selon le plan cristallographique (100). Dans ce cas, le masque 58 peut être par exemple en silice SiO₂ ou en nitrure de silicium Si₃N₄.

La figure 9a est une coupe de la plaquette avec les motifs 58 du masque.

Après un certain temps d'attaque (figure 9b) (telle qu'une attaque chimique préférentielle utilisant par exemple un mélange d'une base et d'un alcool (KOH-méthanol, ou similaire)), le plan (100) horizontal (ou de surface) a été gravé beaucoup plus profondément que les plans de type (111). Les plans de type (111) sont définis par les plans (111) et ($1\overline{1}1$) qui sont situés indifféremment de part et d'autre de la normale au plan de surface. Ces plans sont orientés obliquement et référencés 62. Les angles entre ces différents plans et le plan de surface sont de 54,74°. L'angle des plans 62 par rapport à la normale à la plaquette est de 35,26°.

Après un temps d'attaque encore plus long, le fond 64 s'amenuise encore (figure 9c).

Après un certain temps, le fond a disparu. Les deux plans (111) et ($1\overline{11}$) se rejoignent et forment un profil en V référencé 66 faisant un angle de 70,52° (figure 9d).

La profondeur D évolue ensuite lentement, car la vitesse d'attaque des plans de type (111) est très faible (mais non nulle).

Les plans d'attaque lente (111) ou ($1\overline{11}$) sont ceux qui serviront de support aux moyens piézoélectriques qui pourront comprendre une couche piézoélectrique comprise entre deux électrodes.

On peut obtenir diverses géométries de gravure en fonction de l'angle α que fait la face avant avec le plan (111), de l'écartement p entre deux motifs voisins de la matrice 58 (figures 8 et 9a) et du temps d'attaque.

L'homme du métier saura définir l'angle α suivant le régime de fonctionnement choisi pour la cellule acousto-optique (régime de Bragg, régime de Raman-Nath).

La demande de brevet FR-93 13564 décrit, quant à elle, un microlaser à déclenchement passif par absorbant saturable et le procédé de formation de cet absorbant saturable. Selon ce procédé, un absorbant saturable sous la forme d'une couche mince est déposé directement sur un milieu amplificateur laser. Suivant le mode de dépôt la composition de la couche mince va être différente.

Selon un premier mode de dépôt, la couche mince est composée d'un colorant organique en solution dans un solvant polymère.

De façon plus précise, le colorant organique est choisi parmi le bis(4-diéthylaminodithiobenzyl) nickel ou le bis(4-diméthylaminodithiobenzyl)nickel et que le solvant est une solution de poly(méthyméthacrylate) (PMMA), de poly(vinylalcool) ou de poly(vinyl acétate) ou de poly(styrène).

Typiquement, pour un microlaser fonctionnant à 1,06 μm, on peut utiliser, comme colorant organique le bis(4-diéthylaminodithiobenzyl)nickel (BDN, Kodak, CAS N° 51449-18-4) dans une solution de poly (méthylméthacrylate) (PMMA).

Pour cela, on prépare une solution contenant en masse 6% de poly(méthylméthacrylate) (PMMA, masses moyennes Polyscience) dans du chlorobenzène (Prolabo) en agitant 24 heures. On y rajoute 0,2% en masse de BDN et on agite encore 2 heures. La solution est ensuite filtrée et déposée sur le substrat, sur la face de sortie (opposée à la face d'entrée qui comporte le miroir dichroïque) au goutte à goutte avec un mouvement circulaire centrifuge. On peut utiliser pour ce dépôt à la "tournette" une machine standard telle que celle utilisée en microélectronique pour le dépôt des résines servant aux opérations de lithogravure. Le substrat est préalablement nettoyé de toutes les traces d'impuretés résultant du polissage. Il est mis en rotation (tournette) pendant 20 secondes à 2000 tours/minute, puis pendant 30 secondes à 5000 tours/minute. La couche est enfin mise à sécher 2 heures dans un four à 70°C.

On obtient ainsi un film de 1 μm d'épaisseur contenant 3% de molécules actives (BDN) et dont la densité optique est de 0,13 à 1,06 μm (74% de transmission) avant saturation. Un tel absorbant saturable a un temps de relaxation voisin de 10 ns et sature à une intensité voisine de 1 MW/cm2.

En variant les paramètres de concentration du polymère, sa masse moléculaire ou son solvant, la proportion de colorant ainsi que la vitesse de rotation de la tournette, on peut ajuster les performances de l'absorbant saturable. Les spécifications obtenues typiquement sont :

- épaisseur du film : 1 à 5 μm,
- densité de molécules : 5 à 10% en masse,
- colorant : BDN, mm=685g,
- transition vitreuse : Tg=78°C,
- absorption à 1,06 μm : 10 à 70%,
- taux de saturation : 90%,
- section efficace : $10^{-16}$cm2,
- temps de relaxation : 2 à 15 ns,
- intensité de saturation : 0,1 à 1 MW/cm2,
- non-uniformité du film : <5% sur 1cm2,
- taux de dépolarisation : $<10^{-5}$,
- pertes à 800 nm : <1%,
- fréquence de récurrence : 10-10000 Hz,
- photostabilité : $10^8$ coups,
- technique de dépôt : tournette.

D'autres polymères tels que le poly(vinylalcool) ou le poly(vinylacétate) ou encore poly(styrène) peuvent être employés dans leurs solvants respectifs) à la place du PMMA. On peut aussi utiliser le bis(4-diméthylaminodithiobenzyl)nickel (BDN, Kodak, CAS N°38465-55-3) comme colorant.

Le colorant peut aussi être incorporé dans un gel de silice ou bien greffé à même la chaîne de polymère.

La technique peut aussi être employée pour le déclenchement de lasers fonctionnant à d'autres longueurs d'ondes que 1,06 μm. On déclenchera par exemple des lasers à Er ou Er+Yb (matériaux dopé Er ou Er+Yb où l'ion actif est Er) émettant autour de 1,5 μm avec du tétraéthyloctahydrotétraazapentaphène-dithiolato-nickel.

Avec ce type de dépôt, on obtient des temps de déclin très courts pour le colorant (jusqu'à ~1ns)

Selon un deuxième mode de dépôt, la couche mince est obtenue par épitaxie en phase liquide (EPL). Le procédé de préparation par EPL permet d'obtenir, sur le substrat constitué par le milieu actif solide une couche d'épaisseur comprise entre 1 μm et 500 μm, par exemple 50 μm, 100μm, 200μm, 300μm, 400μm. Elle est constituée d'un matériau de base identique au matériau de base du milieu actif solide (par exemple YAG), mais elle est dopée avec des ions lui conférant des propriétés d'absorbant saturable, par exemple du $Cr^{4+}$ pour un laser à 1,06 µm ou du $Er^{3+}$ pour un laser autour de 1,5 µm.

En fait, on adapte le type de dopant au laser que l'on veut déclencher, afin que la couche épitaxiée présente une absorption saturable à la longueur d'onde d'émission de ce laser.

Par conséquent, le matériau actif laser et la couche d'absorbant saturable sont de même structure cristalline et ne se différencient que par les différents dopants qui affectent les propriétés cristallines et optiques de ces deux milieux.

La couche A.S. (absorbant saturable) est obtenue par trempe du substrat, sur lequel on la dépose, dans une solution sursaturée convenablement choisie. Cette solution ou bain d'épitaxie est un mélange d'un solvant et d'un soluté constitué de différents éléments formant le matériau final.

Ce procédé peut s'appliquer à tout matériau existant sous forme de monocristaux (pour la réalisation des substrats) et pouvant être préparés par épitaxie en phase liquide. C'est le cas des matériaux cités plus haut pour le matériau de base du milieu actif laser : $Y_3A_{15}O_{12}$ (YAG), $Y_2SiO_5$ (YSO), $YVO_4$, $YLiF_4$ (YLF) ou $GdVO_4$. La composition du bain (choix du solvant et des substituants), les concentrations dans le soluté des différents oxydes et les conditions expérimentales de croissance (gamme de températures, mode opératoire, ...) sont ajustées pour chaque matériau afin d'obtenir des couches présentant la meilleure qualité cristalline possible.

Dans le cas des grenats (YAG), le solvant choisi est un mélange $PbO/B_2O_3$ et le soluté comprend un excès de $Al_2O_3$ afin de stabiliser la phase grenat. Le rapport soluté/solvant est alors calculé de façon à obtenir une croissance vers 1000°C.

En fonction de la composition du bain, de la température et du temps de dépôt, on peut ajuster l'épaisseur (1<e<200 µm) et la concentration en dopants dans les couches. La croissance d'une couche a lieu à température constante, ce qui permet d'obtenir une concentration en dopant homogène dans l'épaisseur de la couche. Le substrat est animé d'un mouvement de rotation uniforme ou alternée, ce qui permet une bonne homogénéité d'épaisseur.

Avec ce type de dépôt, les ions constituant les impuretés ($Cr^{4+}$, $Er^{3+}$) ont des temps de déclin de l'ordre de la microseconde.

Les deux modes de dépôt décrits permettent également de réaliser le dépôt d'une couche mince d'absorbant saturable sur un substrat qui est ensuite par exemple mis en contact avec le milieu amplificateur. Par exemple, si ce dernier est du YAG:Nd, le substrat peut être en YAG non dopé.

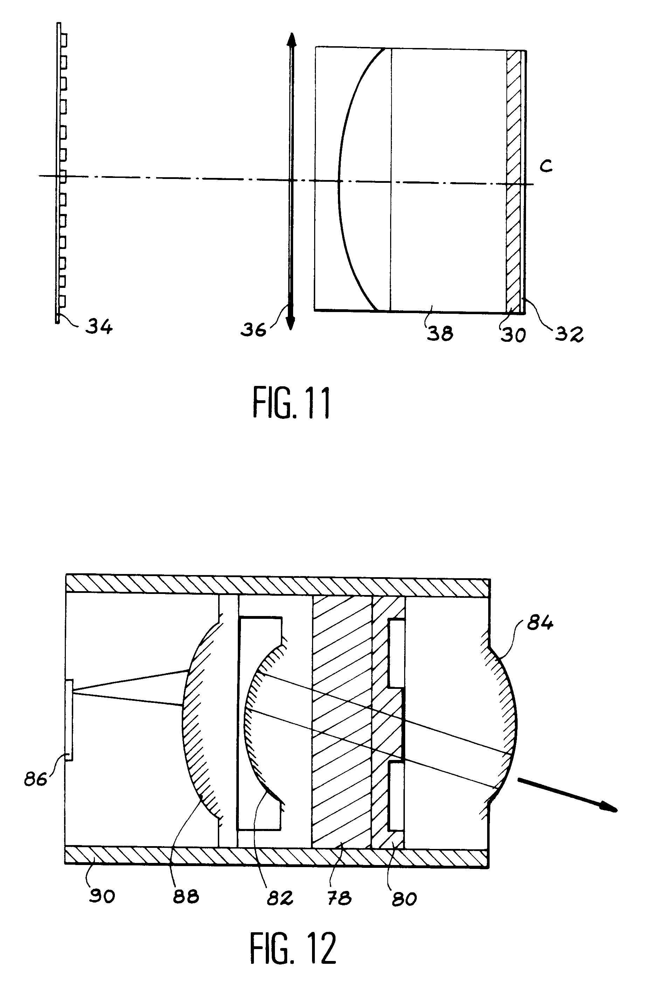

La figure 10 illustre une réalisation de l'invention avec cavité du type concentrique (par exemple avec deux miroirs sphériques), dans le cas de l'utilisation d'une cellule électro-optique ou acousto-optique 20. Les références 24 et 26 représentent respectivement une matrice de sources de lumière et une lentille de focalisation. La cellule 20 est avantageusement placée au voisinage du centre géométrique C de la cavité concentrique, le milieu amplificateur 22 pouvant être soit de part et d'autre de la cellule de déclenchement comme sur la figure 10, soit d'un seul côté. Si on réalise au contraire un déclenchement passif avec une couche mince d'absorbant saturable, la position de cette dernière peut être quelconque au sein de la cavité du microlaser.

L'utilisation d'un absorbant saturable sous forme de couche mince permet d'éviter la nécessité de tout alignement optique des différents composants, l'introduction de colle optique dans la cavité et d'éviter les problèmes liés à une structure où le milieu actif est codopé avec les ions actifs lasers et les ions d'absorbant saturable.

On a illustré, sur la figure 11, une variante de réalisation de l'invention (où le miroir de sortie est plan ou légèrement concave ou convexe) : une cellule électro-optique ou acousto-optique 30 sera là aussi favorablement positionnée au voisinage du centre optique C du miroir sphérique, c'est-à-dire, en fait, juste avant le miroir plan 32. Les références 34, 36, 38 désignent respectivement la matrice de sources de lumière, la lentille de focalisation et le milieu amplificateur. Pour la cellule à absorbant saturable, celle-ci pourra être disposée en position quelconque dans la cavité, bien que dans cette configuration, le positionnement proche du miroir plan paraisse plus naturel, au vu du mode de fabrication collectif des microlasers.

Dans le cas des microlasers, les procédés décrits de réalisation des différents éléments et dans la mesure du possible de leurs assemblages (milieu amplificateur, miroirs, cellule de déclenchement) sont tous des procédés collectifs, c'est-à-dire permettant, pour chacun, de réaliser l'élément correspondant en grande série, et donc à coûts moindres.

Un exemple d'intégration d'un microlaser avec milieu amplificateur (78), cellule de déclenchement (80), miroirs sphériques (82, 84), matrice de diodes de pompage 86 et lentille de collimation 88 est illustré sur la figure 12.

L'ensemble est incorporé dans un boîtier 90. On n'a pas représenté, sur cette figure, les moyens électroniques pour piloter l'adressage de la matrice de diodes de pompage et la cellule de déclenchement, si cette dernière est une cellule électro-optique ou acousto-optique : l'homme du métier saura dans chaque cas choisir et adapter ces moyens.

La possibilité de réaliser de telles structures à coûts moindres semble très avantageuse si on envisage des applications dans le domaine de l'automobile, (pour la détection d'obstacles par exemple). D'autres secteurs d'application, exigeant aussi des composants de taille faible et de coûts de production moindres, peuvent être, à terme, concernés : par exemple la domotique (pour l'orientation de petits appareils) ou l'environnement (détection localisée de polluants ou de zones de fumées, ...).

## Revendications

1. Microlaser comportant une cavité résonante ayant un milieu amplificateur solide (1, 7, 8), un miroir d'entrée (2, 9, 10), un miroir de sortie (3, 11, 12, 21), des moyens optiques (5, 13, 16) pour émettre au moins un faisceau de pompage du milieu amplificateur, caractérisé en ce qu'il comporte une couche mince d'absorbant saturable disposée dans la cavité, des moyens pour faire varier la direction du faisceau de pompage dans le milieu amplificateur et en ce que la cavité a une géométrie permettant de générer un faisceau laser, quelle que soit la direction du faisceau de pompage.

2. Microlaser selon la revendication 1, caractérisé en ce que les moyens de pompage (5, 13, 16) sont constitués d'une matrice de sources de lumière commandables individuellement ou en groupe.

3. Microlaser selon la revendication 1, caractérisé en ce que les moyens de pompage sont constitués d'au moins une source de lumière, et de moyens pour déplacer cette source dans l'espace.

4. Microlaser selon l'une des revendications 1 à 3, caractérisé en ce qu'au moins le miroir d'entrée est un miroir sphérique (2, 10) et en ce que les moyens pour faire varier la direction du faisceau de pompage comportent une lentille de focalisation (6, 18), située sur le trajet du faisceau de pompage, de telle façon que le foyer image de cette lentille soit approximativement confondu avec le centre de courbure du miroir sphérique.

5. Microlaser selon la revendication 4, caractérisé en ce que le deuxième miroir (3) est sphérique, les centres de courbure des deux miroirs étant approximativement confondus.

6. Microlaser selon la revendication 4, caractérisé en ce que le miroir de sortie (12) est plan, ou légèrement concave ou légèrement convexe.

7. Microlaser selon la revendication 1, caractérisé en ce que les moyens de pompage sont constitués d'une barrette de sources de lumière commandables individuellement ou en groupe.

8. Microlaser selon l'une des revendications 1, 3 ou 7, caractérisé en ce qu'au moins le miroir d'entrée est un miroir cylindrique (9) et en ce que les moyens pour faire varier la direction du faisceau de pompage comportent une lentille de focalisation cylindrique (15), située sur le trajet du faisceau de pompage de telle façon que les deux axes de symétrie cylindrique, respectivement du miroir d'entrée et de la lentille, soient disposés selon une même direction et que, dans tout plan perpendiculaire à cette direction, le point focal image de la lentille soit approximativement confondu avec le centre de courbure du miroir dans ce même plan.

9. Microlaser selon la revendication 8, caractérisé en ce que le miroir de sortie est également à symétrie cylindrique (11), et en ce que, dans tout plan perpendiculaire à la direction des deux axes de symétrie, respectivement du miroir d'entrée et de la lentille, le point focal image de la lentille soit approximativement confondu avec le centre de courbure de chaque miroir dans ce même plan.

10. Microlaser selon la revendication 8, caractérisé en ce que le miroir de sortie (12) est plan ou légèrement concave ou légèrement convexe, la concavité ou la convexité étant alors à symétrie cylindrique avec un axe parallèle à l'axe de symétrie cylindrique du miroir d'entrée.

FIG. 1

FIG. 2

FIG. 3

FIG. 4

FIG. 5

FIG. 6a

FIG. 6b

FIG. 6c

FIG. 6d

FIG. 7

FIG. 8

FIG. 10

FIG. 9 a

FIG. 9 b

FIG. 9 c

FIG. 9 d

FIG. 11

FIG. 12

Office européen

des brevets

**RAPPORT DE RECHERCHE EUROPEENNE**

Numero de la demande

EP 95 40 0107

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | KVANTOVAYA ELEKTRONIKA, MOSKVA, JULY 1988, USSR, VOL. 15, NR. 7, PAGE(S) 1323 - 1324, ISSN 0368-7147 Garmash V M et al 'Miniature solid-state laser with semiconductor pumping and frequency conversion, emitting in the ultraviolet spectral range' * page 833, colonne 1, ligne 5 - ligne 14; figure 1 * | 1 | H01S3/101 H01S3/113 |
| A | WO-A-92 03862 (MIT) * page 9, ligne 28 - page 10, ligne 13 * * page 12, ligne 20 - ligne 25 * * page 14, ligne 28 - ligne 30 * | 1,2,7 | |
| A | OPTICS LETTERS, 1 APRIL 1993, USA, VOL. 18, NR. 7, PAGE(S) 511 - 513, ISSN 0146-9592 Zhou S et al 'Monolithic self-Q-switched Cr,Nd:YAG laser' * abrégé * | 1 | |
| A | US-A-3 992 681 (R.D.HAUN ET AL.) * abrégé; figures 1-3 * | 1 | H01S |
| A | GB-A-1 566 716 (GEC CO LTD) * revendication 20 * | 1 | |
| A | FR-A-2 535 535 (CILAS ALCATEL) * abrégé; figures 1,2 * | 1 | |

**DOMAINES TECHNIQUES RECHERCHES (Int.Cl.6)**

H01S

Le présent rapport a été établi pour toutes les revendications

| Lieu de la recherche | Date d'achèvement de la recherche | Examinateur |
|---|---|---|
| LA HAYE | 11 Mai 1995 | Galanti, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)